# EUROPÄISCHE PATENTSCHRIFT

(11) **EP 4 055 315 B1**
(45) Veröffentlichungstag und Bekanntmachung des Hinweises auf die Patenterteilung: **01.11.2023**
(21) Anmeldenummer: 20803155.9
(22) Anmeldetag: 05.11.2020
(51) Int. Cl.: F21K 9/64, H01L 25/075

(54) **LEUCHTSYSTEM ZUR GLEICHMÄSSIG VERTEILTEN ABSTRAHLUNG VON LICHT AUS LICHTQUELLEN**
LIGHTING SYSTEM FOR EVENLY DISTRIBUTED RADIATION OF LIGHT FROM LIGHT SOURCES
SYSTÈME D'ÉCLAIRAGE POUR UN RAYONNEMENT DE LUMIÈRE ÉGALEMENT DISTRIBUÉ DES SOURCES LUMINEUSES

(30) Priorität: 23.12.2019 DE 102019220571
(43) Veröffentlichungstag der Anmeldung: 14.09.2022
(73) Patentinhaber: LightnTec GmbH, 76131 Karlsruhe (DE)
(72) Erfinder: NEHRHOFF VON HOLDERBERG, Lutz, 76227 Karlsruhe (DE)
(74) Vertreter: Kohler Schmid Möbus Patentanwälte
(86) Internationale Anmeldenummer: PCT/EP2020/081204
(87) Internationale Veröffentlichungsnummer: WO 2021/129971

(56) Entgegenhaltungen:
- WO-A1-2009/107052
- US-A1- 2008 093 615
- US-A1- 2014 355 293
- US-A1- 2019 244 938

## Beschreibung

### Hintergrund der Erfindung

Die Erfindung betrifft ein Leuchtsystem zur räumlich gleichmäßig verteilten Abstrahlung von Licht aus Lichtquellen, die Licht verschiedener Spektralbereiche emittieren.

Aus dem Stand der Technik sind Leuchtsysteme bekannt, bei denen Licht aus einer Anordnung von Lasern auf einen Schirm gestrahlt wird. Der Schirm besteht aus Materialien, die Kunststoff und Glas aufweisen und mit Leuchtstoffstreifen beschichtet sind. Die Laserstrahlen überstreichen den Schirm Zeile für Zeile. Dabei bringen die Laserstrahlen die Leuchtstoffstreifen zum Leuchten sodass ein Bild erzeugt wird.

Beispiele für solche Leuchtsysteme sind aus US2019/244938A1, US2014/355293A1 und auch aus WO2009/107052A1 und US2008/093615A1 bekannt.

Diese Leuchtsysteme weisen eine vergleichsweise großräumige und starre Projektionsanordnung auf.

### Aufgabe der Erfindung

Es ist Aufgabe der vorliegenden Erfindung, ein Leuchtsystem bereitzustellen, das kompakt ausgebildet und flexibel an seine Umgebung anpassbar ist.

### Beschreibung der Erfindung

Diese Aufgabe wird erfindungsgemäß gelöst durch ein Leuchtsystem der eingangs genannten Art, wobei das Leuchtsystem aufweist:
a) Lichtquellen eines ersten Typs, die Licht in einem ersten Spektralbereich emittieren,
b) Lichtquellen eines zweiten Typs, die Licht in einem zweiten Spektralbereich emittieren,
c) Lichtquellen eines dritten Typs, die Licht in einem dritten Spektralbereich emittieren,
d) Eine Trägerschicht, auf der die Lichtquellen in regelmäßig voneinander beabstandeten Gruppen angeordnet sind, wobei jede Gruppe drei Lichtquellen aufweist und in jeder Gruppe jede Lichtquelle einem anderen der drei Typen angehört als die anderen Lichtquellen in der Gruppe,
e) Eine in Strahlrichtung der Lichtquellen angeordnete Leuchtstoffschicht aufweisend
   i. einen ersten Leuchtstoff, in einer ersten Leuchtstofffolie, der durch die Lichtquellen des ersten Typs zum Leuchten gebracht wird ,
   ii. einen zweiten Leuchtstoff, in einer in Strahlrichtung der Lichtquellen auf der ersten Leuchtstofffolie angeordneten zweiten Leuchtstofffolie, der durch die Lichtquellen des zweiten Typs zum Leuchten gebracht wird,
   iii. einen dritten Leuchtstoff, in einer in Strahlrichtung der Lichtquellen auf der zweiten Leuchtstofffolie angeordneten dritten Leuchtstofffolie, der durch die Lichtquellen des dritten Typs zum Leuchten gebracht wird .

Das Leuchtsystem ist kompakt ausgebildet und bewirkt energieeffizient, insbesondere CO₂-neutral, eine homogene Ausleuchtung der Leuchtstoffschicht. Das Leuchtsystem ist flexibel und einfach zu installieren. Die Ausleuchtung ist in hohem Maße unabhängig von den Abständen zwischen den Gruppen der Lichtquellen.Mit dem Leuchtsystem lassen sich große Abstrahlwinkel erzielen. Das Leuchtsystem kann gut als Hintergrundbeleuchtung verwendet werden.

Die Leuchtstoffschicht weist die erste, zweite und dritte Leuchtstofffolie auf. Die Lichtquellen weisen insbesondere Laserdioden oder Leuchtdioden auf. Die Leuchtstoffe werden insbesondere jeweils für das von einer Lichtquelle eines Typs emittierte Licht zum Leuchten gebracht und sind für die Lichtquellen der anderen Typen weitestgehend, insbesondere vollständig, transparent. Die Leuchtstoffe leuchten insbesondere durch den Mechanismus der Phosphoreszenz oder Fluoreszenz. Bevorzugt werden Leuchtstoffe verwendet, bei denen die Zeitdauer des Nachleuchtens bei der Phosphoreszenz bei 1 Millisekunde oder weniger liegt. Die verschiedenen Spektralbereiche der von den verschiedenen Lichtquellen emittierten Strahlung weisen insbesondere verschiedene Grenzen auf. Vorzugsweise weisen die verschiedenen Spektralbereiche für verschiedene Wellenlängen Intensitätsmaxima der emittierten Strahlung auf. Bei dem Leuchtsystem handelt es sich insbesondere um eine Spanndecke oder Licht-emittierende Tapete bzw. Lichttapete. Die Trägerschicht ist insbesondere als Trägerfolie ausgebildet. Die Lichtquellen sind innerhalb der Gruppen insbesondere mit einem kleineren Abstand angeordnet als der Abstand zwischen den Gruppen. Die Gruppen von Lichtquellen sind insbesondere in einer Pixelstruktur angeordnet, wobei jedem Pixel eine Gruppe von Lichtquellen zugeordnet ist. Die Gruppen können auch mehr als drei Lichtquellen aufweisen, insbesondere voneinander verschiedene Lichtquellen. Unter Licht wird insbesondere der Teil des elektromagnetischen Spektrums verstanden, der für das menschliche Auge sichtbar ist. Die Erfindung umfasst aber auch Strahlungsquellen, die Strahlung in einem anderen Bereich des elektromagnetischen Spektrums emittieren.

### Bevorzugte Ausführungsformen und Weiterbildungen

Bei einer vorteilhaften Ausführungsform des Leuchtsystems ist die Leuchtstoffschicht von den Lichtquellen mit einem kleineren Abstand beabstandet als der Abstand zwischen den Gruppen der Lichtquellen. Insbesondere befindet sich zwischen der Leuchtstoffschicht und der Trägerschicht eine Luftschicht oder Vakuum. Durch die vergleichsweise dünne Ausgestaltung in der Richtung von der Trägerschicht zur Leuchtstoffschicht lässt sich ein solches Leuchtsystem raumsparend installieren.

Eine weitere vorteilhafte Ausbildung zeichnet sich dadurch aus, dass die Leuchtstoffschicht in Richtung zu der Trägerschicht unmittelbar an einer weiteren Komponente des Leuchtsystems, insbesondere der Trägerschicht, angeordnet ist. Eine Komponente des Leuchtsystems weist insbesondere eine Schicht des Leuchtsystems oder eine Folie auf. Ein solches Leuchtsystem ist besonders dünn ausgebildet.

Bei bevorzugten Ausführungsformen ist zwischen der Leuchtstoffschicht und den Lichtquellen ein mikrooptisches System zur Ablenkung von Licht angeordnet. Das mikrooptische System dient der Streuung des Lichts und damit einer homogeneren Verteilung, insbesondere wenn zwischen den Lichtquellen und der Leuchtstoffschicht ein vergleichsweise kleiner oder kein Abstand vorliegt.

Das mikrooptische System weist mikrooptische Bauelemente auf, die zur Lenkung des in das mikrooptische System eingeleiteten Lichts Linsen-, Prismen-, Polarisator-, Filter-, Phasenplatten-, Spiegel-, Blenden-, Gitterstrukturen, Fasern und/oder Lichtleiter aufweisen. Die mikrooptischen Bauelemente erhalten ihre mikrooptische Funktion durch Formgebung und/oder Änderung der Brechzahl eines optisch gleichmäßigen Ausgangswerkstoffs, insbesondere einer Acrylfolie.

Die Formgebung kann mittels klassischer Verfahren wie Aufschmelzen, Schleifen, Ziehen, Ätzen, Pressen und/oder Polieren erfolgen. Die Aufzählung soll hinsichtlich der genannten Verfahren nicht abschließend verstanden werden.

Das mikrooptische System lenkt unter Verwendung der mikrooptischen Bauelemente, insbesondere durch Anordnung einer Vielzahl mikrooptischer Strukturen, das in das mikrooptische System eingeleitete Licht über festgelegte optische Pfade. Ein optischer Pfad legt dabei den Austrittspunkt und Austrittswinkel eines Lichtstrahls in Abhängigkeit des Eintrittspunkts und des Eintrittswinkels fest. Der Unterschied zu einem gewöhnlichen Diffusor liegt dabei in der inhomogenen Strahlenführung durch das mikrooptische System, während einen Diffusor ein homogener Strahlengang charakterisiert.

Hierzu weist das mikrooptische System eine strukturierte Oberfläche mit sich wiederholenden mikrooptischen Bereichen auf. Die mikrooptischen Bereiche dienen zur Umlenkung des unter verschiedenen Winkeln in das mikrooptische System eingeleiteten Lichts. Die mikrooptischen Bereiche sind vorzugsweise, ausgehend von einem optischen Zentrum, welches in der Nähe, insbesondere genau über, einer Leuchtdiode liegt, überwiegend rotationssymmetrisch, insbesondere kreisförmig und/oder elliptisch, ausgebildet. Die mikrooptischen Bereiche weisen eine größere Fläche als die Leuchtdioden auf.

Die Abmessungen der mikrooptischen Bereiche sind an den Leuchtdiodenabstand angepasst und können in den Erstreckungsrichtungen des mikrooptischen Systems unterschiedlich sein. Insbesondere entsprechen die mikrooptischen Bereiche in ihrem richtungsabhängigen Maß mindestens dem Leuchtdiodenabstand in dieser Erstreckungsrichtung des mikrooptischen Systems. Hierdurch kann gewährleistet werden, dass zumindest bis zu einem halben Leuchtdiodenabstand das von den Leuchtdioden abgestrahlte Licht zuverlässig umgelenkt wird.

Besonders effektiv kann das von den Leuchtdioden abgestrahlte Licht genutzt werden, wenn die benachbarten mikrooptischen Bereiche überlappen. Hierdurch kann Licht unter sehr großen Abstrahlwinkeln genutzt werden.

Das mikrooptische System kann aus Glas, Quarzglas, Polymeren, insbesondere Acryl, und/oder Silicium bestehen. Ebenfalls denkbar ist die Verwendung von Kristallen. Durch Verwendung von Polymeren können die Kosten für die Herstellung des mikrooptischen Systems besonders vorteilhaft gesenkt werden.

Der Begriff Leuchtdiode wird hier stellvertretend für alle lichtemittierenden Dioden, auch Laser-Dioden, Diodenmodule, Diodenbausteine (Dies) usw. verwendet. Dem Fachmann ist bewusst, dass die Verwendung von spezielleren Leuchtdiodenbausteinen zu Modifikationen des Leuchtsystems führen kann. Ebenfalls werden unter dem Begriff der Leuchtdiode alle Farben von Leuchtdioden sowie kombinierte Farben in Leuchtdiodenbausteinen verstanden.

Eine weitere Ausgestaltung sieht vor, dass auf der Leuchtstoffschicht eine Diffusorschicht zur Streuung von Licht angeordnet ist, insbesondere auf der von der Trägerschicht abgewandten Seite der Leuchtstoffschicht. Die Diffusorschicht verstärkt ebenfalls die Homogenisierung des von dem Leuchtsystem abgestrahlten Lichts.

Bei einer bevorzugten Ausführungsform weist die erste Leuchtstofffolie blau leuchtenden Leuchtstoff auf, die zweite Leuchtstofffolie grün leuchtenden Leuchtstoff und die dritte Leuchtstofffolie rot leuchtenden Leuchtstoff, wobei insbesondere die erste Leuchtstofffolie näher an der Trägerschicht angeordnet ist als die zweite Leuchtstofffolie und die zweite Leuchtstofffolie näher an der Trägerschicht angeordnet ist als die dritte Leuchtstofffolie. Durch Kombination der von diesen Leuchtstofffolien jeweils emittierten Strahlung lässt sich jede Farbe erzeugen.

Vorteilhaft sind die Lichtquellen als Leuchtdioden ausgebildet. Leuchtdioden zeichnen sich durch eine hohe Lebensdauer und geringen Energieverbrauch sowie ein schmalbandiges Emissionsspektrum aus.

Bei einer weiteren Ausgestaltung des Leuchtsystems strahlen die Lichtquellen Licht im blauen Bereich des optischen Spektrums aus, wobei sich insbesondere die Intensitätsmaxima des von den Lichtquellen des ersten, zweiten und dritten Typs emittierten Lichts voneinander unterscheiden und vorzugsweise in einem Spektralbereich von 380 nm bis 480 nm liegen, wobei insbesondere das Intensitätsmaximum der Lichtquelle des ersten Typs bei 405 nm bis 422 nm, vorzugsweise 410 nm, das Intensitätsmaximum der Lichtquelle des zweiten Typs bei 425 nm bis 442 nm, vorzugsweise 430 nm, und das Intensitätsmaximum der Lichtquelle des dritten Typs bei 445 nm bis 460 nm, vorzugsweise 450 nm liegt. Blaues Licht wird insbesondere stark gestreut, sodass das Licht bereits vergleichsweise gleichmäßig verteilt die Leuchtstofffolien erreicht.

Bevorzugt sind die Gruppen der Lichtquellen in einem rechteckigen Schema angeordnet. Die Gruppen sind insbesondere in einem quadratischen Schema angeordnet. Das Schema weist insbesondere die Form einer Matrix auf. Bei einer solchen Anordnung der Lichtquellen ist bereits die auf die Leuchtstoffschicht treffende, von den Lichtquellen emittierte Strahlung vergleichsweise homogen verteilt.

Die Lichtquellen sind bevorzugt dazu ausgebildet, mit einer Pulsweitenmodulation betrieben zu werden. Insbesondere werden die Lichtquellen mit einer vorgegebenen, vorzugsweise für das menschliche Auge nicht wahrnehmbaren Frequenz an- und ausgeschaltet. Dadurch wird insbesondere die wahrgenommene Helligkeit der Lichtquellen und damit des Leuchtsystems beeinflusst.

Bei einer weiteren Ausführungsform weist die Trägerschicht ein Metall, insbesondere Kupfer, auf. Insbesondere weist die Trägerschicht eine Kupfermatrix und/oder Indium-Zinnoxid und/oder eine aufgedruckte Silberschicht zur Ausbildung einer, insbesondere flexiblen, Leiterplatte für die Lichtquellen auf.

Bei einer weiteren Ausführungsform weist das Leuchtsystem eine mehrlagige Leuchtfolie mit mehreren Leuchtdioden, einer Leiterbahnenlage zur elektrischen Verbindung der Leuchtdioden und eine Trägerlage auf, wobei die Leuchtfolie eine erste mikrooptische Lage zur Erzeugung einer homogenen Ausleuchtung aufweist. Die erste mikrooptische Lage ist insbesondere als ein mikrooptisches System oder weiteres mikrooptisches System ausgebildet.

Bevorzugt ist eine Ausführungsform, bei der die Leuchtfolie an der lichtabstrahlenden Folienoberfläche eine textile Lage oder eine Vlieslage aufweist. Eine textile Lage oder Vlieslage ermöglicht eine besonders homogene Ausleuchtung der Leuchtfolie und weist zudem akustische Vorteile auf.

Eine bevorzugte Weiterbildung sieht vor, dass die textile Lage oder die Vlieslage durch Beflockung der Leuchtfolie ausgebildet ist. Mittels Beflockung lässt sich die textile Lage oder die Vlieslage besonders einfach und kostengünstig bereits während der Fertigung der Leuchtfolie herstellen. Ebenso ist denkbar, die Beflockung erst zu einem späteren Zeitpunkt nach Fertigung der Leuchtfolie, beispielweise nach Montage der Leuchtfolie aufzubringen. Hierdurch kann die textile Lage oder Vlies besonders gut vor Beschädigungen geschützt werden.

In einer besonders bevorzugten Weiterbildung besteht die Beflockung aus einem Mischgranulat unterschiedlichster Granulatkörper und/oder Fasern. Hierdurch lässt sich besonders vorteilhaft eine unregelmäßige Ausbildung der Beflockung realisieren, was eine besonders hohe Schallabsorption der Leuchtfolie begünstigt. Alternativ oder zusätzlich kann das Granulat aus lichtdurchlässigen, insbesondere transparenten, Granulatkörpern und/oder Fasern bestehen, wodurch die Ausleuchtung der Leuchtfolie ebenfalls verbessert werden kann.

Alternativ oder zusätzlich zu einer textilen Lage, einem Vlies und/oder einem Gewebe kann eine oberseitige Schicht, insbesondere ein Silikatputz, Flüssigtapete, anti-bakterielle und/oder eine anti-haftende Schicht vorgesehen sein.

Weiterhin bevorzugt ist eine Ausführungsform, bei der die erste mikrooptische Lage die Leuchtdioden überwiegend, insbesondere vollständig, umschließt. Hierdurch kann das von den Leuchtdioden abgestrahlte Licht besonders effektiv durch die mikrooptische Lage gelenkt, der Lichtverlust gesenkt und die Gleichmäßigkeit der Ausleuchtung der Leuchtfolie weiter erhöht werden.

Die mikrooptische Lage ist vorzugsweise in Form einer gestempelten und/oder gepressten Lage ausgebildet. Alternativ oder zusätzlich dazu kann die mikrooptische Lage einstückig ausgebildet sein. Die mikrooptischen Bauelemente können in Form einer planaren, integrierten Optik der mikrooptischen Lage ausgebildet sein.

In einer bevorzugten Ausführungsform weist die Leuchtfolie eine Spiegellage auf, die sich in Abstrahlrichtung der Leuchtfolie hinter den Leuchtdioden befindet. Eine derartige Spiegellage reflektiert gegen die Leuchtrichtung der Leuchtfolie abgestrahltes Licht und gewährleistet eine noch effektivere und verlustärmere Nutzung des abgestrahlten Lichts der Leuchtdioden.

In einer besonders bevorzugten Ausführungsform bildet die Spiegellage und die Trägerlage eine gemeinsame Lage. Dies ermöglicht die besonders effektive und kostengünstige Fertigung der Leuchtfolie, da die Spiegellage bereits bei der Fertigung der Trägerlage entsteht. Hierdurch kann die Spiegellage zudem besonders dünn ausgeführt werden.

Bei Nutzung einer Spiegellage kann die mikrooptische Lage besonders effektiv in Abstrahlrichtung der Leuchtfolie hinter den Leuchtdioden und vor der Spiegellage angeordnet werden. Hierdurch kann der optische Pfad durch die mikrooptische Lage verlängert oder die mikrooptische Lage besonders dünn ausgebildet werden. Das von den Leuchtdioden entgegen der Abstrahlrichtung der Leuchtfolie abgestrahlte Licht wird in diesem Fall zuerst entgegen der Abstrahlrichtung der Leuchtfolie durch die mikrooptische Lage bis zu der Spiegellage gelenkt. Die Spiegellage reflektiert das ankommende Licht in Richtung der Abstrahlrichtung der Leuchtfolie, wodurch das Licht ein weiteres Mal durch die mikrooptische Lage gelenkt wird, um schließlich an der Oberfläche der Leuchtfolie auszutreten. Hierdurch wird die Effektivität der Lichtlenkung durch die mikrooptische Lage sowie der Anteil des genutzten Lichts weiter gesteigert.

Bevorzugt ist eine Ausführungsform, bei der die Folie eine weitere mikrooptische Lage mit mikrooptischen Bauelementen aufweist, wobei die Leuchtdioden zwischen den zwei mikrooptischen Lagen angeordnet sind. Hierdurch kann eine effektive Lichtlenkung besonders günstig realisiert werden und der Aufwand der Fertigung kann sich auf die Anordnung der Lagen reduzieren.

Besonders bevorzugt ist eine Ausführungsform, bei der die Trägerlage aus einer Folie, einem Vlies und/oder einem Gewebe, insbesondere einem Textil, besonders bevorzugt einem Papier, besteht. Dies bietet den Vorteil eines breiten Anwendungsbereichs, da die Trägerlage auf die vorherrschenden Bedingungen des Einsatzortes angepasst werden können. In besonderer Weiterbildung kann die Trägerlage lichtdurchlässig, insbesondere vollständig transparent, ausgebildet sein. Hierdurch kann die Leuchtwirkung der Leuchtfolie beidseitig ausgeführt werden.

Bevorzugt ist weiterhin eine Ausführungsform, bei der die Leiterbahnenlage teilweise lichtdurchlässig, insbesondere vollständig lichtdurchlässig, ausgebildet ist. Die Lichtdurchlässigkeit der Leiterbahnenlage ermöglicht deren Anordnung, in Abstrahlrichtung der Leuchtfolie, vor den Leuchtdioden, ohne dass die Leiterbahnen zur Störung der Leuchtwirkung der Leuchtfolie führen.

In einer bevorzugten Ausführungsform kann die Leiterbahnenlage aus Kupfer, elektrisch leitender Tinte, Indium-Zinkoxid und/oder Silberoxid bestehen.

Weiterhin bevorzugt ist eine Ausführungsform, bei der die textile Lage oder die Vlieslage unidirektional lichtdurchlässig, insbesondere in Abstrahlrichtung der Leuchtfolie, ausgerichtet ist. Hierdurch kann die Leuchtwirkung der Leuchtfolie besonders gleichmäßig ausgeführt werden.

Besonders bevorzugt ist eine Ausführungsform, bei der die textile Lage oder die Vlieslage zumindest teilweise akustisch schallhart und/oder schallweich ist. Dies ermöglicht den Einsatz der Leuchtfolie in Bereichen mit akustischen Vorgaben oder zur Verbesserung der akustischen Bedingungen. Je nach Vorgabe kann die textile Lage daher schallabsorbierend und/oder schallreflektierend ausgebildet werden.

In einer Ausführungsform ist vorgesehen, dass die Leuchtdioden einen Abstand zwischen 1 Millimeter und 200 Millimeter, insbesondere zwischen 4 Millimeter und 150 Millimeter, besonders bevorzugt zwischen 8 Millimeter und 100 Millimeter, aufweist.

In besonderer Ausführungsform beträgt der Füllfaktor der Leuchtfolie bei homogener Ausleuchtung zwischen 5 und 50%, insbesondere zwischen 7 und 25%, besonders bevorzugt zwischen 9 und 15%.

Bevorzugt ist eine Ausführungsform, bei der die Foliendicke der Leuchtfolie 0,1 Millimeter bis 40 Millimeter, insbesondere 0,2 Millimeter bis 30 Millimeter, besonders bevorzugt 0,3 Millimeter bis 20 Millimeter, beträgt. Die Dicke der Leuchtfolie bezieht sich dabei auf die überwiegende Foliendicke ohne Berücksichtigung einer optionalen textilen Lage.

Besonders bevorzugt ist eine Ausführungsform, bei der die Leuchtfolie biegbar, insbesondere rollbar, ausgebildet ist. Insbesondere beträgt der Biege- und/oder Rollradius zwischen 1 Zentimeter und 10 Zentimeter, besonders bevorzugt zwischen 2 Zentimeter und 5 Zentimeter.

Weiterhin bevorzugt ist eine Ausführungsform, bei der die Steuerung der Leuchtdioden an, insbesondere in, besonders bevorzugt direkt an den Leuchtdioden, der Leuchtfolie angeordnet ist. Eine derart angeordnete Steuerung vereinfacht die Installation sowie die Lieferung der Leuchtfolie und verringert den benötigten Platz zur Anbringung der Leuchtfolie.

Weitere Vorteile der Erfindung ergeben sich aus der Beschreibung und der Zeichnung. Ebenso können die vorstehend genannten und die noch weiter ausgeführten Merkmale jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

- Fig. 1: zeigt eine schematische Ansicht einer ersten Ausführungsform des Leuchtsystems;
- Fig. 2: zeigt eine schematische Ansicht einer zweiten Ausführungsform des Leuchtsytems.

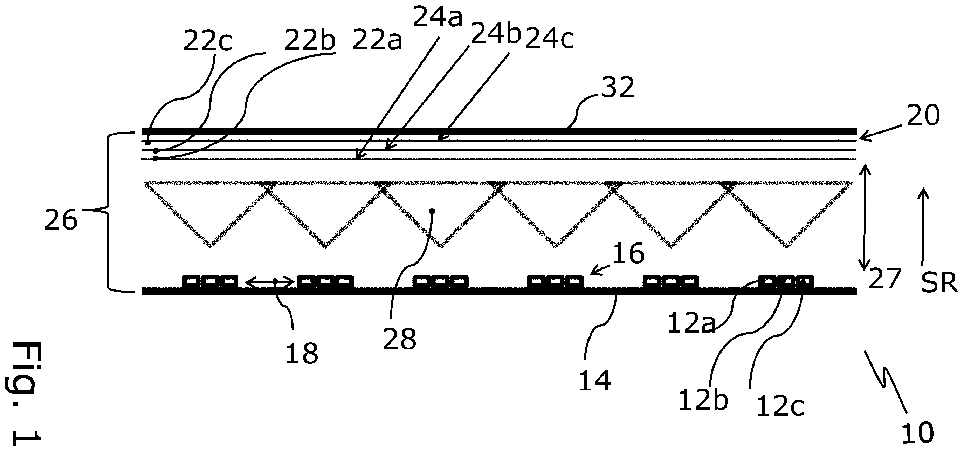

Das in **Fig. 1** gezeigte erfindungsgemäße Leuchtsystem **10** zur räumlich gleichmäßig verteilten Abstrahlung von Licht aus Lichtquellen **12a, 12b, 12c,** die Licht verschiedener Spektralbereiche emittieren, verfügt in einer ersten Ausführungsform über Lichtquellen 12a eines ersten Typs, die Licht in einem ersten Spektralbereich emittieren, Lichtquellen 12b eines zweiten Typs, die Licht in einem zweiten Spektralbereich emittieren und Lichtquellen 12c eines dritten Typs, die Licht in einem dritten Spektralbereich emittieren. Auf einer Trägerschicht **14** sind die Lichtquellen 12a, 12b, 12c in Gruppen **16** angeordnet, die in einem Gruppierungsabstand **18** regelmäßig voneinander beabstandet sind. Jede Gruppe 16 weist drei Lichtquellen 12a, 12b, 12c auf, wobei in jeder Gruppe 16 jede Lichtquelle 12a, 12b, 12c einem anderen der drei Typen angehört als die anderen Lichtquellen 12a, 12b, 12c in der Gruppe 16. Das Leuchtsystem 10 weist eine in Strahlrichtung **SR** der Lichtquellen 12a, 12b, 12c angeordnete Leuchtstoffschicht **20** auf. Die Leuchtstoffschicht 20 hat eine erste Leuchtstofffolie **22a** mit einem ersten Leuchtstoff **24a,** der durch die Lichtquellen 12a des ersten Typs zum Leuchten gebracht wird. In Strahlrichtung SR der Lichtquellen 12a, 12b, 12c ist auf der ersten Leuchtstofffolie 22a eine zweite Leuchtstofffolie **22b** mit einem zweiten Leuchtstoff **24b** angeordnet, der durch die Lichtquellen 12b des zweiten Typs zum Leuchten gebracht wird. Eine dritte Leuchtstofffolie **22c** mit einem dritten Leuchtstoff **24c,** der durch die Lichtquellen 12c des dritten Typs zum Leuchten gebracht wird, ist in Strahlrichtung SR der Lichtquellen 12a - 12c auf der zweiten Leuchtstofffolie 22b angeordnet. Die erste Leuchtstofffolie 22a weist blau leuchtenden Leuchtstoff 24a auf. Die zweite Leuchtstofffolie 22b weist grün leuchtenden Leuchtstoff 24b auf. Die dritte Leuchtstofffolie 22c weist rot leuchtenden Leuchtstoff 24c auf. Durch Kombination der von den Leuchtstofffolien 22a - 22c emittierten Strahlung lassen sich alle gewünschten Farben erzeugen. Die erste Leuchtstofffolie 22a ist näher an der Trägerschicht 14 angeordnet als die zweite Leuchtstofffolie 22b. Die zweite Leuchtstofffolie 22b ist näher an der Trägerschicht 14 angeordnet als die dritte Leuchtstofffolie 22c. Die Höhe **26** des Leuchtsystems 10 in Strahlrichtung SR der Lichtquellen 12a - 12c liegt im Bereich von 20 mm bis 100 mm.

Zwischen der Leuchtstoffschicht 20 und den Lichtquellen 12a - 12c ist ein Schichtenabstand **27** ausgebildet. Insbesondere befindet sich zwischen der Leuchtstoffschicht 20 und der Trägerschicht 14 eine Luftschicht, in der sich Lichtkegel **28** der verschiedenen Gruppen 16 von Lichtquellen 12a - 12c zur Homogenisierung überlagern können. Auf der Leuchtstoffschicht 20 befindet sich auf der von der von der Trägerschicht 14 abgewandten Seite der Leuchtstoffschicht 20 eine Diffusorschicht **32** zur Streuung von Licht, insbesondere aus den Lichtquellen 12a - 12c. Die Lichtquellen 12a - 12c sind insbesondere als Leuchtdioden ausgebildet.

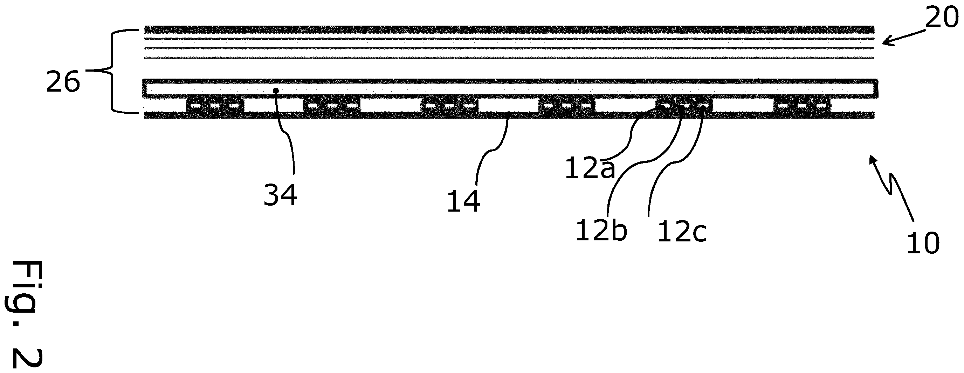

Die in **Fig. 2** gezeigte zweite Ausführungsform des Leuchtsystems 10 weist ein mikrooptisches System **34** zwischen den Lichtquellen 12a - 12c und der Leuchtstoffschicht 20 auf, das zur Ablenkung von Licht aus den Lichtquellen 12a - 12c und damit zu einer Homogenisierung dieses Lichtes dient. Dadurch kann die Höhe 26 des Leuchtsystems 10 mit einem Wert von 3 mm bis 10 mm deutlich kleiner ausgebildet sein als bei der ersten Ausführungsform.

Unter Vornahme einer Zusammenschau aller Figuren der Zeichnung betrifft die Erfindung ein Leuchtsystem 10 zur räumlich gleichmäßig verteilten Abstrahlung von Licht aus ersten, zweiten und dritten Lichtquellen 12a - 12c, wobei sich die Spektralbereiche des von den verschiedenen Lichtquellen 12a - 12c emittierten Lichts voneinander unterscheiden, mit einer Halteschicht bzw. Trägerschicht 14, auf der sich die Lichtquellen 12a - 12c in Gruppen von jeweils einer der ersten, zweiten und dritten Lichtquellen 12a - 12c befinden und mit einer Luminophorschicht 20, die in Ausbreitungsrichtung des Lichts aus den Lichtquellen 12a - 12c angeordnet ist und die eine erste, zweite und dritte Leuchtstofffolie 22a - 22c aufweist, wobei der Leuchtstoff 24a - 24c jeder Leuchtstofffolie 22a - 22c jeweils weitestgehend, insbesondere ausschließlich, durch die ersten, zweiten oder dritten Lichtquellen 12a - 12c zum Leuchten angeregt wird.

## Patentansprüche

1. Leuchtsystem (10) zur räumlich gleichmäßig verteilten Abstrahlung von Licht aus Lichtquellen (12a - 12c), die Licht verschiedener Spektralbereiche emittieren, aufweisend
a) Lichtquellen (12a) eines ersten Typs, die Licht in einem ersten Spektralbereich emittieren
b) Lichtquellen (12b) eines zweiten Typs, die Licht in einem zweiten Spektralbereich emittieren
c) Lichtquellen (12c) eines dritten Typs, die Licht in einem dritten Spektralbereich emittieren
d) Eine Trägerschicht (14), auf der die Lichtquellen (12a - 12c) in regelmäßig voneinander beabstandeten Gruppen (16) angeordnet sind, wobei jede Gruppe (16) drei Lichtquellen (12a - 12c) aufweist und in jeder Gruppe (16) jede Lichtquelle (12a - 12c) einem anderen der drei Typen angehört als die anderen Lichtquellen (12a - 12c) in der Gruppe (16),
e) Eine in Strahlrichtung (SR) der Lichtquellen (12a - 12c) angeordnete Leuchtstoffschicht (20) aufweisend
i. einen ersten Leuchtstoff in einer ersten Leuchtstofffolie (22a), der durch die Lichtquellen (12a) des ersten Typs zum Leuchten gebracht wird,
ii. einen zweiten Leuchtstoff in einer in Strahlrichtung (SR) der Lichtquellen (12a - 12c) auf der ersten Leuchtstofffolie (22a) angeordneten zweiten Leuchtstofffolie (22b), der durch die Lichtquellen (12b) des zweiten Typs zum Leuchten gebracht wird,
iii. einen dritten Leuchtstoff in einer in Strahlrichtung (SR) der Lichtquellen (12a - 12c) auf der zweiten Leuchtstofffolie (22b) angeordneten dritten Leuchtstofffolie (22c), der durch die Lichtquellen (12c) des dritten Typs zum Leuchten gebracht wird.

2. Leuchtsystem nach einem der vorhergehenden Ansprüche, wobei die Leuchtstoffschicht (20) von den Lichtquellen (12a - 12c) mit einem kleineren Abstand (27) beabstandet ist als der Abstand (18) zwischen den Gruppen (16) der Lichtquellen (12a - 12c).

3. Leuchtsystem nach Anspruch 1, wobei die Leuchtstoffschicht (20) in Richtung zu der Trägerschicht (14) unmittelbar an einer weiteren Komponente des Leuchtsystems (10), insbesondere der Trägerschicht (14), angeordnet ist.

4. Leuchtsystem nach einem der vorhergehenden Ansprüche, wobei zwischen der Leuchtstoffschicht (20) und den Lichtquellen (12a - 12c) ein mikrooptisches System (34) zur Ablenkung von Licht angeordnet ist.

5. Leuchtsystem nach einem der vorhergehenden Ansprüche, wobei auf der Leuchtstoffschicht (20) eine Diffusorschicht (32) zur Streuung von Licht angeordnet ist, insbesondere auf der von der Trägerschicht (14) abgewandten Seite der Leuchtstoffschicht (20).

6. Leuchtsystem nach einem der vorhergehenden Ansprüche, wobei die erste Leuchtstofffolie (22a) blau leuchtenden Leuchtstoff (24a) aufweist, die zweite Leuchtstofffolie (22b) grün leuchtenden Leuchtstoff (24b) aufweist und die dritte Leuchtstofffolie (22c) rot leuchtenden Leuchtstoff (24c) aufweist, wobei insbesondere die erste Leuchtstofffolie (22a) näher an der Trägerschicht (14) angeordnet ist als die zweite Leuchtstofffolie (22b) und die zweite Leuchtstofffolie (22b) näher an der Trägerschicht (14) angeordnet ist als die dritte Leuchtstofffolie (22c).

7. Leuchtsystem nach einem der vorhergehenden Ansprüche, wobei die Lichtquellen (12a - 12c) als Leuchtdioden ausgebildet sind.

8. Leuchtsystem nach einem der vorhergehenden Ansprüche, wobei die Lichtquellen (12a - 12c) Licht im blauen Bereich des optischen Spektrums ausstrahlen, wobei insbesondere das Intensitätsmaximum der Lichtquelle (12a) des ersten Typs bei 405 nm bis 422 nm, vorzugsweise 410 nm, das Intensitätsmaximum der Lichtquelle (12b) des zweiten Typs bei 425 nm bis 442 nm, vorzugsweise 430 nm, und das Intensitätsmaximum der Lichtquelle (12c) des dritten Typs bei 445 nm bis 460 nm, vorzugsweise 450 nm liegt.

9. Leuchtsystem nach einem der vorhergehenden Ansprüche, wobei die Gruppen (16) der Lichtquellen (12a - 12c) in einem rechteckigen Schema angeordnet sind.

10. Leuchtsystem nach einem der vorhergehenden Ansprüche, wobei die Lichtquellen (12a - 12c) dazu ausgebildet sind, mit einer Pulsweitenmodulation betrieben zu werden.

11. Leuchtsystem nach einem der vorhergehenden Ansprüche, wobei die Trägerschicht (14) ein Metall, insbesondere Kupfer, aufweist.

## Claims

1. Lighting system (10) for the spatially evenly distributed emission of light from light sources (12a-12c) which emit light in different spectral ranges, comprising
a) light sources (12a) of a first type, which emit light in a first spectral range
b) light sources (12b) of a second type, which emit light in a second spectral range
c) light sources (12c) of a third type, which emit light in a third spectral range
d) a carrier layer (14), on which the light sources (12a-12c) are arranged in groups (16) which are regularly spaced apart from each other, wherein each group (16) comprises three light sources (12a-12c) and in each group (16) each light source (12a-12c) belongs to a different one of the three types than the other light sources (12a-12c) in the group (16),
e) a luminescent-material layer (20) arranged in the beam direction (SR) of the light sources (12a-12c), comprising
i. a first luminescent material in a first luminescent-material film (22a), which is caused to luminesce by the light sources (12a) of the first type,
ii. a second luminescent material in a second luminescent-material film (22b) arranged on the first luminescent-material film (22a) in the beam direction (SR) of the light sources (12a-12c), which is caused to luminesce by the light sources (12b) of the second type,
iii. a third luminescent material in a third luminescent-material film (22c) arranged on the second luminescent-material film (22b) in the beam direction (SR) of the light sources (12a-12c), which is caused to luminesce by the light sources (12c) of the third type.

2. Lighting system according to any of the preceding claims, wherein the luminescent-material layer (20) is spaced apart from the light sources (12a-12c) at a smaller distance (27) than the distance (18) between the groups (16) of the light sources (12a-12c).

3. Lighting system according to claim 1, wherein the luminescent-material layer (20) is arranged directly on a further component of the lighting system (10), in particular the carrier layer (14), in the direction of the carrier layer (14).

4. Lighting system according to any of the preceding claims, wherein a micro-optical system (34) for deflecting light is arranged between the luminescent-material layer (20) and the light sources (12a-12c).

5. Lighting system according to any of the preceding claims, wherein a diffuser layer (32) for scattering light is arranged on the luminescent-material layer (20), in particular on the side of the luminescent-material layer (20) that faces away from the carrier layer (14).

6. Lighting system according to any of the preceding claims, wherein the first luminescent-material film (22a) comprises blue-light-emitting luminescent material (24a), the second luminescent-material film (22b) comprises green-light-emitting luminescent material (24b) and the third luminescent-material film (22c) comprises red-light-emitting luminescent material (24c), wherein in particular the first luminescent-material film (22a) is arranged closer to the carrier layer (14) than the second luminescent-material film (22b) and the second luminescent-material film (22b) is arranged closer to the carrier layer (14) than the third luminescent-material film (22c).

7. Lighting system according to any of the preceding claims, wherein the light sources (12a-12c) are designed as light-emitting diodes.

8. Lighting system according to any of the preceding claims, wherein the light sources (12a-12c) emit light in the blue range of the optical spectrum, wherein in particular the maximum intensity of the light source (12a) of the first type is 405 nm to 422 nm, preferably 410 nm, the maximum intensity of the light source (12b) of the second type is 425 nm to 442 nm, preferably 430 nm, and the maximum intensity of the light source (12c) of the third type is 445 nm to 460 nm, preferably 450 nm.

9. Lighting system according to any of the preceding claims, wherein the groups (16) of the light sources (12a-12c) are arranged in a rectangular pattern.

10. Lighting system according to any of the preceding claims, wherein the light sources (12a-12c) are designed to be operated with pulse width modulation.

11. Lighting system according to any of the preceding claims, wherein the carrier layer (14) comprises a metal, in particular copper.

## Revendications

1. Système d'éclairage (10) dédié au rayonnement de lumière, à diffusion uniforme dans l'espace, émanant de sources lumineuses (12a-12c) qui émettent de la lumière de différentes plages spectrales, comprenant
a) des sources lumineuses (12a) d'un premier type, émettant de la lumière dans une première plage spectrale,
b) des sources lumineuses (12b) d'un deuxième type, émettant de la lumière dans une deuxième plage spectrale,
c) des sources lumineuses (12c) d'un troisième type, émettant de la lumière dans une troisième plage spectrale,
d) une couche de substrat (14) sur laquelle lesdites sources lumineuses (12a-12c) sont agencées en des groupes (16) uniformément espacés les uns des autres, sachant que chaque groupe (16) compte trois sources lumineuses (12a-12c) et que, dans chaque groupe (16), chaque source lumineuse (12a-12c) appartient, au sein des trois types, à un type autre que ceux des autres sources lumineuses (12a-12c) dans ledit groupe (16),
e) une couche (20) de substance luminescente qui est disposée dans la direction (SR) du rayonnement des sources lumineuses (12a-12c) et comprend,
i. dans un premier film (22a) de substance luminescente, une première substance luminescente illuminée par les sources lumineuses (12a) du premier type,
ii. dans un deuxième film (22b) de substance luminescente mis en place sur le premier film (22a) de substance luminescente, dans la direction (SR) du rayonnement des sources lumineuses (12a-12c), une deuxième substance luminescente illuminée par les sources lumineuses (12b) du deuxième type,
iii. dans un troisième film (22c) de substance luminescente mis en place sur le deuxième film (22b) de substance luminescente, dans ladite direction (SR) du rayonnement des sources lumineuses (12a-12c), une troisième substance luminescente illuminée par les sources lumineuses (12c) du troisième type.

2. Système d'éclairage selon l'une des revendications précédentes, dans lequel la couche (20) de substance luminescente est espacée, des sources lumineuses (12a-12c), d'une distance (27) inférieure à la distance (18) séparant les groupes (16) desdites sources lumineuses (12a-12c).

3. Système d'éclairage selon la revendication 1, dans lequel la couche (20) de substance luminescente est disposée, dans la direction pointant vers la couche de substrat (14), directement sur un composant autre dudit système d'éclairage (10), en particulier sur ladite couche de substrat (14).

4. Système d'éclairage selon l'une des revendications précédentes, dans lequel un système micro-optique (34), affecté à la déviation de lumière, est interposé entre la couche (20) de substance luminescente et les sources lumineuses (12a-12c).

5. Système d'éclairage selon l'une des revendications précédentes, dans lequel une couche de diffusion (32) affectée à la dispersion de lumière est disposée sur la couche (20) de substance luminescente, en particulier du côté de ladite couche (20) de substance luminescente qui est tourné à l'opposé de la couche de substrat (14).

6. Système d'éclairage selon l'une des revendications précédentes, dans lequel le premier film (22a) de substance luminescente comporte une substance luminescente (24a) à illumination bleue, le deuxième film (22b) de substance luminescente comporte une substance luminescente (24b) à illumination verte et le troisième film (22c) de substance luminescente comporte une substance luminescente (24c) à illumination rouge, sachant notamment que le premier film (22a) de substance luminescente est plus rapproché de la couche de substrat (14) que le deuxième film (22b) de substance luminescente, et que ledit deuxième film (22b) de substance luminescente est plus rapproché de ladite couche de substrat (14) que le troisième film (22c) de substance luminescente.

7. Système d'éclairage selon l'une des revendications précédentes, dans lequel les sources lumineuses (12a-12c) sont réalisées en tant que diodes électroluminescentes.

8. Système d'éclairage selon l'une des revendications précédentes, dans lequel les sources lumineuses (12a-12c) diffusent de la lumière dans la gamme des bleus du spectre optique, sachant notamment que le maximum d'intensité de la source lumineuse (12a) du premier type est de 405 nm à 422 nm, préférentiellement de 410 nm, que le maximum d'intensité de la source lumineuse (12b) du deuxième type est de 425 nm à 442 nm, préférentiellement de 430 nm, et que le maximum d'intensité de la source lumineuse (12c) du troisième type est de 445 nm à 460 nm, préférentiellement de 450 nm.

9. Système d'éclairage selon l'une des revendications précédentes, dans lequel les groupes (16) des sources lumineuses (12a-12c) sont agencés en une configuration rectangulaire.

10. Système d'éclairage selon l'une des revendications précédentes, dans lequel les sources lumineuses (12a-12c) sont conçues pour être exploitées avec une modulation de largeurs d'impulsions.

11. Système d'éclairage selon l'une des revendications précédentes, dans lequel la couche de substrat (14) comporte un métal, du cuivre en particulier.
